# EUROPEAN PATENT SPECIFICATION

(11) **EP 0 412 301 B1**
(45) Date of publication and mention of the grant of the patent: **07.12.1994**
(21) Application number: 90113083.1
(22) Date of filing: 09.07.1990
(51) Int. Cl.: C23C 16/34, G01N 25/18, G03F 1/14

(54) **Boron nitride membrane in wafer structure**
Bornitridmembran in einer Halbleiterplättchenstruktur
Membrane en nitrure de bore dans un dispositif semi-conducteur

(30) Priority: 11.07.1989 US 377979; 21.06.1990 US 540043
(43) Date of publication of application: 13.02.1991
(73) Proprietor: Redwood MicroSystems, Inc., Menlo Park, California (US)
(72) Inventor: America, William G., Bethel, CT 06801 (US); Poole, Richard R., Norwalk, CT 06850 (US)
(74) Representative: Grünecker, Kinkeldey, Stockmair & Schwanhäusser Anwaltssozietät

(56) References cited:
- EP-A- 0 289 249
- PROC.-ELECTROCHEM. SOC., vol. 89-12 (PROC. INT. SYMP. DIAMOND DIAMOND-LIKEFILMS, 1ST 1989), pages 182-201; R.A. LEVY: "Characterization of boron nitride films for synchrotron X-ray masks"
- JOURNAL OF VACUUM SCIENCE & TECHNOLOGY/SECTION B, vol.6, no. 1, January-February 1988, pages 154-161, Woodbury, NY, US; R.A. LEVY et al.: "An improved boron nitride technology for synchrotron x-ray masks"

## Description

This invention relates to miniature devices and particularly to laminated structures including a membrane.

### BACKGROUND OF THE INVENTION

Miniaturized devices have been suggested for effecting various mechanical functions. Such devices are fabricated utilizing the techniques of integrated electronic circuit production, as described, for example, in an article "Silicon as a Mechanical Material" by K. E. Petersen, Proc. IEEE 70, 420-457 (May 1982). One field of application of the device components is gas chromatography, in which chromatographic columns, injectors, valves and detectors are integrated into a device formed primarily of laminated silicon wafers. The reference discloses a hot wire detector in which the thin film heater is supported by a silicon membrane in a chamber duct of flowing gas. It is necessary that membranes utilized in such devices have good rigidity, at least some flexibility and, in some critical areas, high temperature stability.

The reference also describes a solenoid valve. An improved valve for such a system is disclosed in "A Microminiature Electric-to Fluidic Valve" by M. J. Zdeblick and J. B. Angell, Transducers 87, pp 827-829 (1987). The valve utilizes a sealed cavity filled with a liquid. One wall of the cavity is formed with a flexible membrane which can press against a pneumatic nozzle. When the liquid is heated, its pressure increases, pushing the membrane toward the nozzle and turning off the valve.

Silicon nitride is mentioned in the Peterson reference as a masking material, and is suggested for use in strain sensors as disclosed in "Deposition Techniques and Properties of Strain Compensated LPCVD Silicon Nitride Films" by H. Guckel, D. K. Showers, D. W. Burns and C. R. Rutigliano, Technical Digest, IEEE Solid State Sensors (June 2-5, 1986). A problem with silicon nitride is that its coefficient of thermal expansion is about half that of silicon, with a corresponding tendency to stress rupture.

Boron nitride deposited by chemical vapor deposition (CVD) is used as a component material as a mask for etching silicon as taught in "Boron Nitride Mask Structure for X-Ray Lithography" by D. Maydan, G. A. Coquin, H. J. Levinstein, A. K. Sinha and D. N. K. Wang, J. Vac. Sci. Technol 16 (6) 1959 (1979). CVD boron nitride is generally in the form of BN and, due to the chemical process, contains hydrogen. The hydrogenated BN changes stress with time and temperature, becoming very tensive to the point of rupture.

From EP-A-289249, R.A. Levy: "Characterization of boron nitride films for synchrotron x-ray masks", Proceedings of the Electrochemical Society, vol. 89-12 (Proceedings International of the Symposium a Diamond and Diamond-like films, 1st 1989), pages 182 to 201, and R.A. Levy, et al: "An improved boron nitride technology for synchrotron x-ray masks", Journal of Vacuum Science and Technology/Section B, vol. 6, no. 1, January-February 1988, pages 154 to 161, Woodbury, NY, US, a boron nitride membrane and a method for fabricating the same is known wherein such a boron nitride technology is used for synchrotron x-ray masks for x-ray lithography. The known boron nitride membranes are composed of a boron nitride film and a layer of inherently sensile hydrogen-free B₃N.

Greater precision is always a goal in producing such devices, particularly for further miniaturization. In the case of fluid flow devices, smoothly rounded channels are important to minimize resistance to flow and allow more precise control over cross sectional areas. However, conventional masking for etchants tends to produce an undesirable form of anisotropic etching, resulting in nonuniformity of etched channels. For example etching of a 〈100〉 silicon wafer having a mask of silicon dioxide or boron nitride, results in outside corners being etched with additionally tilted faces from 〈110〉 and 〈310〉 planes, and inside corners being perpendicular sharp corners. Although smooth channels are depicted in the literature, in practice actually etched channels and cavities are not so smooth. In chromatographic operation sharp inside corners may result in peak distortion caused by flow trapping in a corner.

Therefore, objects of the present invention are to provide an improved laminated structure for use in miniaturized devices, to provide a laminated structure with an improved masking layer, to provide a novel membrane material for laminated structures, to provide improved miniature mechanical devices including a gas flow detector and a gas valve, and to provide a process for forming a novel membrane material on a wafer.

Further objects of the present invention are to provide a novel process for forming a mask on a silicon wafer and to provide an improved mask thereby, to provide an improved boron diffusion layer on silicon useful for masking against certain etchants, and to provide a process that allows favorable anisotropic etching for forming smoothly rounded channels in the silicon surface.

### SUMMARY OF THE INVENTION

The foregoing and other objects are achieved, according to the present invention, with a laminated structure according to claims 1 and 5 and with a process according to claim 11. According to one aspect of the invention the structure comprises a body formed of at least two wafer members laminated together with a cavity formed therebetween, with the boron nitride membrane extending into the cavity so as to provide the structural component. Preferably the wafer member is formed of single crystal silicon, and a silicon dioxide film may be disposed as a bonding layer between the boron nitride membrane and the wafer member. Alternatively the boron nitride membrane is in the form of a masking layer on the wafer member for masking etching of the wafer member.

The objects are further achieved by a process for forming a boron nitride membrane on a wafer member, comprising depositing by low pressure chemical vapor deposition a hydrogenated boron nitride film on a wafer member, and heating the boron nitride film in an environment free of hydrogen and oxygen at a sufficiently high temperature and for a sufficient time period to transform the boron nitride film to substantially hydrogen-free boron nitride having a nominal composition B₃N.

In another aspect of the invention, foregoing and other objects are also achieved by a process for forming a step with a smooth wall in a wafer member, comprising diffusing boron into a portion of a selected area of a 〈100〉 surface of a silicon wafer member to form a boron diffusion layer, and exposing the selected area to a selective etchant to which the boron diffusion layer is resistant. The unetched boron diffusion layer thereby forms a step adjacent etched silicon in the wafer member with a smooth wall substantially perpendicular to the 〈100〉 surface. The smooth wall may define a side of a fluid flow channel with smoothly rounded contours.

### BRIEF DESCRIPTION OF THE DRAWINGS

FIG. 1 is a cross section of a laminated structure of the invention.

FIG. 2 is exploded perspective of a gas thermal conductivity detector utilizing the invention.

FIG. 3 is a cross-section of a gas valve utilizing the invention.

FIG. 4 is a cross section of a laminated structure including a masking layer according to the invention.

FIG. 5 is a cross section of a laminated structive illustrating steps in a process of the invention.

FIG. 6 is a perspective of a portion of a miniaturized device formed according to the invention.

### DETAILED DESCRIPTION OF THE INVENTION

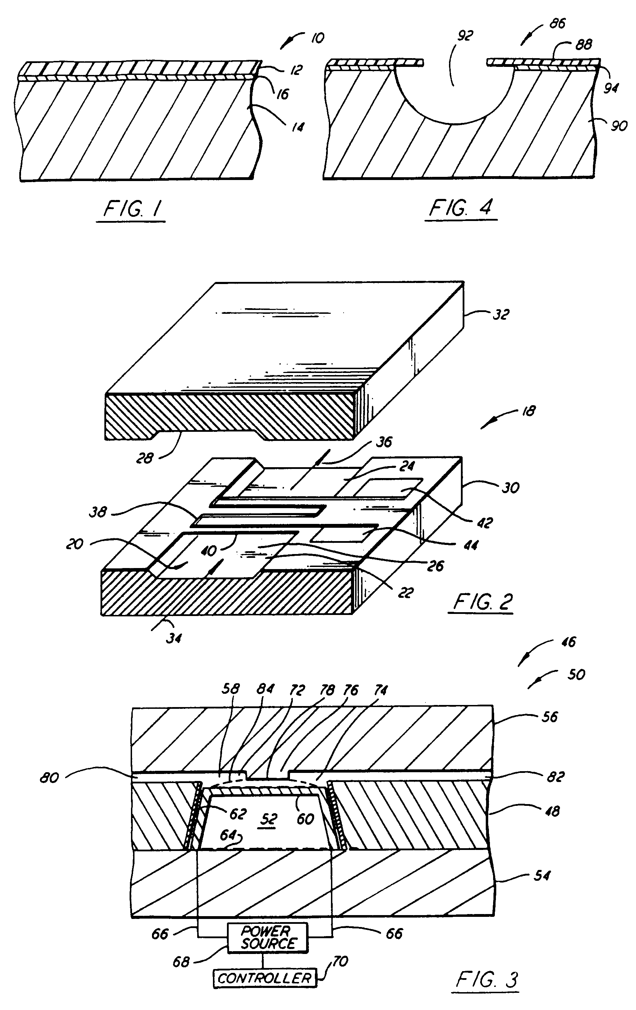

FIG. 1 depicts a portion of a miniaturized laminated structure **10** in a simple mode, in which a membrane **12** is formed on a wafer member **14**. The membrane is advantageously formed on a wafer member of single crystal silicon. An intermediate layer **16** may also be formed between the membrane and the wafer. The intermediate layer may be silicon dioxide or, as explained below, a modified form of the membrane material.

According to the present invention the membrane is formed of boron-rich, substantially hydrogen-free boron nitride having a nominal composition B₃N. Preferably this is produced by a process comprising depositing by low pressure chemical vapor deposition a hydrogenated boron nitride film on a wafer, the film being nominally BNH₃. The film is heated in an environment free of hydrogen and oxygen at a sufficiently high temperature and for a sufficient time to transform the boron nitride film to substantially hydrogen-free boron nitride having a composition nominally B₃N, generally between about BN and B₃N. A suitable temperature is between about 1050°C and 1150°C, and the time should exceed about one hour, e.g. up to about 12 hours. Preferable conditions are 1100 °C in nitrogen or vacuum for 4 hours. The resulting membrane may be between 1 and 15 microns thick, depending on application.

The initial hydrogenated boron nitride film is deposited by conventional low pressure chemical vapor deposition (LPCVD) of BN type boron nitride. This is effected on a precleaned (as by conventional etching) silicon wafer by reacting a gas containing 5 mols of ammonia and 1 mol of diborane at 340°C for 10 to 25 hours depending on desired thickness, using nitrogen as a carrier gas.

It is particularly useful for the boron nitride membrane to be applied to silicon because such a substrate is conveniently etched to fabricate mechanical devices. Also the boron-rich nitride of the invention matches silicon very well in thermal expansion, favorable for maintaining bonding in varying temperature conditions.

Formation of the transformed boron nitride membrane directly on silicon generally results in a well defined intermediate layer **16** of boron doped silicon, the boron concentration being about 10²¹ to 10²² atoms/cm³. This intermediate layer is about 0.1 to 50 microns thick and provides excellent bonding for the membrane.

If the depleted boron nitride intermediate layer is not desired, a silicon dioxide film may be disposed to form layer **16** between boron nitride membrane **12** and silicon wafer member **14**. A thickness of the film of about one micron is sufficient to act as a diffusion barrier for boron. The oxide layer is formed prior to the initial deposition of boron nitride. Oxide formation is by conventional means such as, after cleaning the silicon surface, heating the wafer in air or oxygen to 1100°C for 2 hours. The initial boron nitride layer then is deposited as described above. The boron nitride bonds to the oxide very well.

According to one aspect of the invention a laminated structure of the wafer and boron-rich, hydrogen-free boron nitride is utilized as a component in a mechanical device for effecting a mechanical function. In such a case the structure may comprise a body formed of at least two wafer members laminated together with a cavity formed therebetween, with the boron nitride membrane extending into the cavity so as to provide a structural component. One wafer member is preferably silicon and the other may also be silicon or may be quartz or a high silica glass such as Pyrex (TM). The component may be stationary or may have a moving part, and in particular the membrane may be utilized in a flexing or other motion.

As an example of a stationary component incorporating the invention, in one preferred embodiment the mechanical device is a detector for measuring thermal conductivity of a gas. FIG. 2 illustrates a hot wire type of gas thermal conductivity detector **18** of the general type disclosed in the Petersen article. A detector cavity **20** has a gas inlet **22** and an outlet **24**. The cavity is conveniently formed by adjacent grooves **26,28** etched in adjacent wafers **30,32**. A flowing gas is shown by arrows **34,36**. A hot wire electrical resistive element **38** formed conventionally as a thin film of platinum or the like is deposited in a serpentine path on a bridge **40** formed of hydrogen free, B₃N boron nitride, e.g. 2-3 microns thick. The bridge divides grooves **26** and **28**. Electrical connections **42,44** for current and voltage measurement are provided for the element. Change in thermal conductively of the flowing gas, is detected by the corresponding change of resistance of the thin film resistance and is measured by voltage measurement such as with a Wheatstone bridge.

In another embodiment illustrating a movable membrane the mechanical device incorporating the membrane is a fluid valve. One such valve **46** shown in FIG. 3. A middle wafer **48** of a laminate **50** has therein a first cavity **52** closed off by a bottom wafer **54**. An upper wafer **56** has therein a second cavity **58** adjacent to cavity **52**. A membrane **60** of hydrogen-free B₃N is disposed in laminate body **50** so as to separate the first and second cavities. Other layers **62** of depleted boron nitride or silicon dioxide may be used for bonding the boron nitride to wafer **48**. Electrical heating element strips **64** of aluminum or the like for operating the valve are also deposited adjacent cavity **52** on bottom wafer **54** and connected by electrical leads **66** to a source **68** of electrical current responsive to a controller **70** which may be incorporated as integrated electronic circuits into the overall device. Upper cavity **58** is divided into an inlet portion **72** and an outlet portion **74** by a protrusion **76** extending from upper wafer **56** to a surface location **78** proximate membrane **60** but spaced slightly therefrom. An inlet gas passage **80** etched into wafer **56** extends to the inlet cavity and an outlet gas passage **82** extends from the outlet cavity. The valve will also be useful for liquid.

Lower cavity **52** is filled with a medium such as liquid methyl chloride as disclosed in Zdbelick et al, which will expand significantly when heated by element **64**, preferably by partially vaporizing. The expansion will cause membrane **60** to distend into the upper cavity, as shown by broken lines **84**, to a sealing surface at location **78** on protrusion **76** to close off outlet portion **74** from inlet portion **72**. Thus in a non-distended, relaxed position the membrane allows gas to flow between the passages, and current to the heating element results in the membrane distending to close off gas flow.

According to a further aspect of a laminated structure **86** of the invention the boron nitride membrane is formed as a mask **88** on a wafer member **90** for masking etching of a groove **92** of the wafer member, FIG. 4. The membrane for this purpose may be relatively thin, e.g. 1 microns. A silica layer **94** may be present and an intermediate, boron diffusion layer **96** also may be present but minimal (0.5 microns) due to the silica barrier. The membrane is deposited, converted and then conventionally masked such as with a photoresist. The membrane then is selectively patterned with an etchant that does not attack the silicon wafer, for example with CF₄/O₂ (96:4 volume) as a reactive ion source, exposed at 13,3 Pa (100 mtorr), 30cc/min flow, 100 watts RF. The boron nitride is immune to ordinary etchant environments for the silicon. Such etchants include EDP (ethylene diamine-pyrocatechol), KOH (40 vol % at 90°C) and HNA (hydrofluoric, nitric and acetic acids - 8:2:1).

Selective etching to produce a pattern in the membrane may be effected in other ways. One is to remove the initial BNH₃ film from a selected portion of the wafer surface prior to heating the wafer with the film to the high temperature for the appropriate time period. The step of removing the film comprises the substeps of selectively applying a premask layer of a conventional photoresist onto the intended remaining portion of the boron nitride film.

A cyclic deflection test was run on a boron membrane formed according to the invention, 2.5 cm diameter and 2 microns thick. It was vibrated acoustically at its resonant frequency of 1.8 MHz. The vibrational deflection of +/- 3 microns remained unchanged for the duration of the test which was 6 billion deflections, indicating no significant work hardening. It is estimated that this cycling was the equivalent to 10 years of normal operation in a valve at 8 hours per day, 5 days per week. retains a low stress of about 2 x 10⁴ N/cm (2 x 10⁹ dynes/cm). This The transformed boron nitride is thermally stable for long periods of time at elevated temperatures exceeding 400°C and characteristic and membrane rigidity are particularly suitable for a membrane to support or be proximate to electrically heated films for such applications as described above. Platinum film filaments deposited on the membrane about 0.5 microns thick are a further example.

As mentioned above, formation of the transformed boron nitride membrane directly on clean silicon results in a well defined intermediate layer **18** (FIG. 1) which consists essentially of boron diffused in silicon, i.e. boron doped silicon. In the case of no silica barrier layer, under the preferred heat treatment it was found that diffusion of the boron into 〈100〉 oriented silicon occurs at a linear rate of about one micron per minute for at least 25 minutes, i.e. to 25 microns thickness. Further thickness of diffusion is expected to occur up to at least 50 microns. According to a further embodiment this diffusion layer may be used advantageously as a secondary masking layer, or as a primary mask with the B₃N layer fully or selectively removed, or as a standing component of the silicon device as explained below.

To operate as a good mask, resistant to etchant, the boron should be present in the silicon in a concentration of at least about 10¹⁹ atoms/cm³, but should not fully replace the silicon, the maximum boron being about 1x10²³, referenced to a neat silicon density of about 6x10²³. A concentration achieved according the preferred conditions described above, and indeed a preferred concentration, is about 10²² atoms/cm³.

The masking layer of diffused boron is especially useful for the etchant ethylene diame-pyrocatechol (EDP) in water in proportions E 35.1 mole %, D-P 3.7 mole % and H₂O 61.2 mole %, with the addition of pyrazine 2 g/l of solution. This is preferably used at about 118 °C for 5 to 120 minutes. Silicon etchant is about 2 microns/minute.

A particularly advantageous way to provide masking of a pattern for selective etching is to selectively expose the wafer surface to oxygen in the conventional manner, such as by heating in air or oxygen to 1100°C for 2 hours, to form a silicon dioxide film selectively patterned on the wafer surface prior to depositing the boron nitride. The boron diffusion is thus inhibited by the silica in the selected portion, whereby the masking layer of boron in silicon is formed only on certain areas of the surface.

The etchant EDP etches neat silicon but not the boron doped silicon. Furthermore, etching by such a selective etchant of silicon with a patterned boron diffusion layer results in well defined, smooth cavities and channels. The boron diffusion layers follow 〈111〉 planes of 〈100〉 oriented silicon wafers. This anisotropy of diffusion makes controlled selective diffusion practical. In a contoured pattern etching with EDP (or other similarly selective etchant) follows the 〈111〉 planes with smoothly rounded inside and outside curves bounded by 〈111〉 crystal planes on a small scale, compared with the large sharp corners of the prior art. This effect is particularly useful to provide improved microfluidic devices in achieving even, full sweeping flow of gases and liquids.

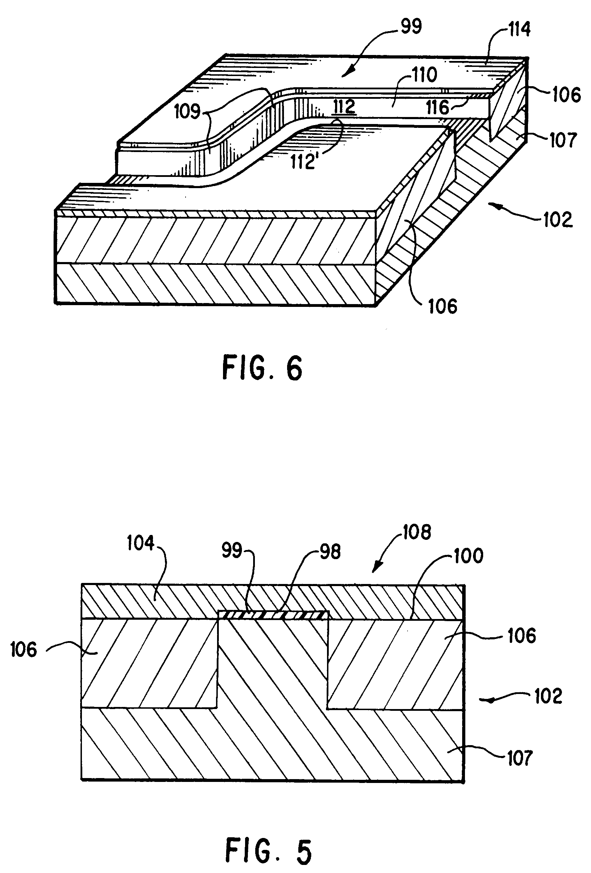

FIGS. 5 and 6 illustrate the formation of a smooth channel in a device for fluid flow or the like, according to these concepts. With reference to FIG. 5, a silicon dioxide film **98** is deposited in a selected pattern **99** on a clean 〈100〉 surface **100** of the wafer member **102**. A boron nitride layer **104**, is produced at 1100^{o}C in the manner described herein so that a boron diffusion layer **106** is formed under the boron nitride antithetically to the selected pattern, i.e. where no silicon dioxide is removed, leaving undoped silicon **107** elsewhere. The boron nitride and the silicon dioxide are etched away using a general etchant such as CF₄/0₂ and HNA respectively in a selected area **108** (e.g. the entire upper surface in the figure) encompassing at least the pattern **98** and conveniently at least a portion of the boron diffusion layer **106**. BN may be left if other processes are planned for further device processing.

The selected area **108** is then exposed to a selective etchant such as EDP to which the boron diffusion layer is **106** resistant. As shown in FIG. 6 the pattern **99** illustrated has an "S" shape with rounded contours **109**. The boron diffusion layer **106**, being unetched, forms a step **110** adjacent the etched (i.e. removed) silicon region in the wafer member, with a smooth wall **112** substantially perpendicular to the 〈100〉 surface. A thin (2 micron) layer of BN **114** may remain, etched back slightly with a small (1 micron) shoulder **116**. A second smooth wall **112'** forms the other side of the "S" shaped channel **99** in the wafer. The walls **112** have smooth roundings corresponding to rounded contours of the pattern. With appropriate selection of the contours, such a channel may be used for fluid flow devices, such as the thermal conductivity detector or fluid valve described herein.

Where the boron nitride membrane is not necessary, the boron diffusion layer may be formed by any other available and convenient method on a masked surface of 〈100〉 silicon. However use of the hydrogen-free B₃N is quite suitable.

In addition to fluid devices such as for gas chomatography, it will be appreciated that there are many other potential applications for a miniaturized laminated structure according to one or more embodiments of the invention. These include silicon storage devices, ink jet nozzles, fibre-optic couples, laser resonators, thermopile detectors, voltage detectors, pressure transducers, torsion bar and cantilever structures, electron-beam/optical projection assemblies, accelerometers electromechanical switches and thermal print heads.

## Claims

1. A laminated structure comprising:
an upper wafer member (32);
a lower wafer member (30), said upper and lower wafer members coupled together so as to define a cavity (20); and
a membrane (40), said membrane (40) coupled to said lower wafer member (30), said membrane (40) being formed of substantially hydrogen-free boron nitride having a nominal composition of B₃N, said membrane (40) extending into said cavity (20) between said upper and lower wafer members, said membrane being a structural component inside said cavity (20).

2. The use of a structure according to claim 1 wherein the laminated structure is a detector for measuring thermal conductivity of a gas, the cavity (20) in the body is adapted to pass a gas therethrough with a boron nitride membrane (40) forming a bridge extending laterally through the cavity (20), and the structure further comprises a thin film resistor (38) being supported by the bridge and receptive of a heating current and voltage measurement to provide a measure of thermal conductivity of the gas.

3. The use of a structure according to claim 1 wherein the laminated structure is a fluid valve, wherein the cavity in the body is adapted to pass a fluid therethrough, the boron nitride membrane extends across the cavity, and the device further comprises distending means for distending the boron nitride membrane into the cavity such to restrict passage of fluid through the cavity.

4. The use of a structure according to claim 3 wherein the cavity is divided into a first cavity and a second cavity by the boron nitride membrane, the second cavity is adapted to pass the fluid therethrough, and the distending means comprises a thermally expandable medium filling the first cavity and further comprises heating means for heating the medium to expand the medium such that the membrane is caused to distend into the second cavity whereby passage of fluid through the second cavity is restricted.

5. A laminated structure comprising:
an upper wafer member (56);
a lower wafer member(54);
a middle wafer member (48), said upper, middle, and lower wafer members coupled together so as to define a cavity (52,58);
a membrane (60) said membrane coupled to said middle wafer member (48), said membrane (60) being formed of substantially hydrogen-free boron nitride having a nominal composition of B₃N, said membrane (60) extending into said cavity (52,58) so as to define an upper portion (58) and a lower portion (52) of said cavity, said upper portion (58) of said cavity located between said upper wafer member (56) and said membrane (60) and adapted to pass a fluid, said lower portion (52) of said cavity extending into said middle wafer member (48) and bounded by said membrane (60) and said lower wafer member (54);
a thermally expandable medium filling said lower cavity (52); and
means (64) for heating said medium in order to expand said medium so that said membrane (60) distends into said upper cavity (58) and restricts passage of said fluid.

6. The structure according to claim 1 wherein the lower wafer member is formed of single crystal silicon.

7. The structure according to claim 6, further comprising a silicon dioxide film disposed as a bonding layer between the boron nitride membrane and the lower wafer member.

8. The structure according to claim 6 further comprising an intermediate layer disposed between the boron nitride membrane and the lower wafer member, the intermediate layer being formed of boron doped silicon.

9. The structure according to claim 1 wherein the boron nitride membrane is formed by a process comprising depositing by low pressure chemical vapor deposition a hydrogenated boron nitride film on the lower wafer member, and heating the boron nitride film in an environment free of hydrogen and oxygen at a sufficiently high temperature and for a sufficient time period to transform the boron nitride film to the substantially hydrogen-free boron nitride.

10. The structure according to claim 9 wherein the temperature is between about 1050°C and 1150°C and the time period exceeds about one hour.

11. A process for forming a step with a smooth wall in a wafer member, comprising diffusing boron into a portion of a selected area of a 〈100〉 surface of a silicon wafer member to form a boron diffusion layer, and exposing the selected area to a selective etchant to which the boron diffusion layer is resistant, whereby the boron diffusion layer forms a step adjacent etched silicon in the wafer member with a smooth wall substantially perpendicular to the 〈100〉 surface.

12. The process according to claim 11 wherein the portion of selected area has rounded contours so that the smooth wall includes smooth roundings corresponding to the contours.

13. The process according to claim 11 wherein the selective etchant is ethylene diamine-pyrocatechol.

14. The process according to claim 11 wherein the boron is present in the diffusion layer in an amount between 10¹⁹ and 10²³ atoms/cm³.

15. A minaturized device comprising a silicon wafer member having a step therein with a smooth wall, formed by the process according to claim 11 or 12 or 13.

16. The device according to claim 15 wherein the smooth wall defines a side of a fluid flow channel in the wafer member.

## Patentansprüche

1. Eine Schichtstruktur mit:
einem oberen Waferteil (32);
einem unteren Waferteil (30), wobei die oberen und unteren Waferteile derart miteinander gekoppelt sind, daß sie einen Hohlraum (20) bestimmen; und
einer Membran (40), wobei die Membran (40) mit dem unteren Waferteil (30) gekoppelt ist, wobei die Membran (40) aus im wesentlichen wasserstoffreiem Bornitrid mit einer nominalen Zusammensetzung von B₃N gebildet ist, wobei die Membran (40) sich in den Hohlraum (20) zwischen dem oberen und unteren Waferteil erstreckt, und wobei die Membran eine Bauteilkomponente innerhalb des Hohlraums (20) ist.

2. Die Verwendung einer Struktur gemäß Anspruch 1, wobei die Schichtstruktur ein Detektor zum Messen einer thermischen Leitfähigkeit eines Gases ist, wobei der Hohlraum (20) in dem Körper geeignet ausgebildet ist, um ein Gas dadurch hindurch zu lassen, und eine Bornitridmembran (40) aufweist, die eine sich lateral durch den Hohlraum (20) erstreckende Brücke bildet, und wobei die Struktur weiter einen Dünnfilmwiderstand (38) umfaßt, der durch die Brücke gehalten ist und für einen Heizstrom und eine Spannungsmessung zugänglich ist, um ein Maß der thermischen Leitfähigkeit des Gases zu schaffen.

3. Die Verwendung einer Struktur nach Anspruch 1, wobei die Schichtstruktur ein Fluidventil ist, wobei der Hohlraum in dem Körper geeignet ausgebildet ist, um ein Fluid dadurch hindurch zu lassen, wobei sich die Bornitridmembran durch den Hohlraum erstreckt und wobei die Vorrichtung weiter eine Ausdehnungsvorrichtung umfaßt, um die Bornitridmembran in den Hohlraum derart auszudehnen, daß der Fluiddurchgang durch den Hohlraum eingeschränkt wird.

4. Die Verwendung einer Struktur nach Anspruch 3, wobei der Hohlraum in einen ersten Hohlraum und einen zweiten Hohlraum durch die Bornitridmembran getrennt ist, wobei der zweite Hohlraum geeignet ausgebildet ist, um ein Fluid dadurch hindurchtreten zu lassen, und wobei die Ausdehnungsvorrichtung ein thermisch ausdehnbares Medium umfaßt, das den ersten Hohlraum füllt, und wobei weiter eine Heizvorrichtung vorgesehen ist zum Heizen des Mediums, um das Medium derart auszudehnen, daß bewirkt wird, daß die Membran sich in den zweiten Hohlraum ausdehnt, wodurch der Durchgang des Fluids durch den zweiten Hohlraum eingeschränkt wird.

5. Eine Schichtstruktur mit:
einem oberen Waferteil (56);
einem unteren Waferteil (54);
einem mittleren Waferteil (48), wobei die oberen, mittleren und unteren Waferteile derart miteinander gekoppelt sind, daß sie einen Hohlraum (52,58) bestimmen;
einer Membran (60), wobei die Membran mit dem mittleren Waferteil (48) gekoppelt ist, wobei die Membran (60) aus im wesentlichen wasserstoffreiem Bornitrid mit einer nominalen Zusammensetzung von B₃N gebildet ist, wobei die Membran (60) sich derart in den Hohlraum (52,58) erstreckt, daß ein oberer Bereich (58) und ein unterer Bereich (52) des Hohlraums bestimmt wird, wobei der obere Bereich (58) des Hohlraums, der zwischen dem oberen Waferteil (56) und der Membran (60) gelegen ist, geeignet ausgebildet ist, um ein Fluid hindurchtreten zu lassen, und wobei der untere Bereich (52) des Hohlraums sich in das mittlere Waferteil (48) erstreckt und durch die Membran (60) und das untere Waferteil (54) begrenzt wird;
einem thermisch ausdehnbarem Medium, das den unteren Hohlraum (52) füllt; und
einer Vorrichtung (64) zum Heizen des Mediums, um das Medium derart auszudehnen, daß die Membran (60) sich in den oberen Hohlraum (58) ausdehnt und den Durchgang des Fluids einschränkt.

6. Die Struktur gemäß Anspruch 1, wobei das untere Waferteil aus einkristallinem Silizium gebildet ist.

7. Die Struktur gemäß Anspruch 6, die weiter einen Siliziumdioxidfilm umfaßt, der als Haftschicht zwischen der Bornitridmembran und dem unteren Waferteil angebracht ist.

8. Die Struktur gemäß Anspruch 6, die weiter eine Zwischenschicht umfaßt, die zwischen der Bornitridmembran und dem unteren Waferteil angebracht ist, wobei die Zwischenschicht aus bordotiertem Silizium gebildet ist.

9. Die Struktur nach Anspruch 1, wobei die Bornitridmembran durch ein Verfahren gebildet wird, umfassend das Ablagern eines Wasserstoff enthaltenden Bornitridfilms auf dem unteren Waferteil durch eine chemische Gasphasenablagerung bei geringem Druck und das Aufheizen des Bornitridfilms in einer wasserstoff- und sauerstoffreien Umgebung bei einer ausreichend hohen Temperatur und für eine ausreichend lange Zeitdauer, um den Bornitridfilm in im wesentlichen wasserstoffreies Bornitrid umzuwandeln.

10. Die Struktur nach Anspruch 9, wobei die Temperatur zwischen 1050°C und 1150°C liegt und die Zeitdauer 1 Stunde überschreitet.

11. Ein Verfahren zum Ausbilden einer Stufe mit einer glatten Wand in einem Waferteil, umfassend ein Eindiffundieren von Bor in einen Abschnitt eines ausgewählten Gebiets einer 〈100〉 Oberfläche eines Siliziumwaferteils, um eine Bordiffusionsschicht zu bilden, und Aussetzen des ausgewählten Gebiets an ein selektives Ätzmittel, gegen das die Bordiffusionsschicht resistent ist, wodurch die Bordiffusionsschicht eine Stufe angrenzend an das geätzte Silizium in dem Waferteil mit einer glatten Wand bildet, die im wesentlichen senkrecht zu der 〈100〉 Oberfläche ist.

12. Das Verfahren nach Anspruch 11, wobei der Bereich des ausgewählten Gebiets abgerundete Umrißlinien aufweist, so daß die glatte Wand glatte Abrundungen entsprechend den Umrißlinien enthält.

13. Das Verfahren nach Anspruch 11, wobei das selektive Ätzmittel Ethylendiamin-pyrocatechol ist.

14. Das Verfahren gemäß Anspruch 11, wobei Bor in der Diffusionsschicht in einer Menge von zwischen 10¹⁹ und 10²³ Atomen/cm³ vorhanden ist.

15. Ein miniaturisiertes Bauelement mit einem Siliziumwaferteil, in dem eine Stufe mit einer glatten Wand vorhanden ist, die durch das Verfahren gemäß den Ansprüchen 11 oder 12 oder 13 gebildet ist.

16. Die Vorrichtung nach Anspruch 15, wobei die glatte Wand eine Seite eines Fluidströmungskanals in dem Waferteil bestimmt.

## Revendications

1. Structure stratifiée comprenant :
un membre de tranche supérieur (32);
un membre de tranche inférieur (30), lesdits membres supérieur et inférieur étant couplés ensemble de façon à définir une cavité (20); et
une membrane (40), ladite membrane (40) étant couplée audit membre de tranche inférieur (30), ladite membrane (40) étant formée de nitrure de bore substantiellement exempt d'hydrogène ayant la composition nominale B₃N, ladite membrane (40) s'étendant dans ladite cavité (20) entre lesdits membres de tranche supérieur et inférieur, ladite membrane étant un composant structurel à l'intérieur de ladite cavité (20).

2. Utilisation de la structure selon la revendication 1 dans laquelle la structure stratifiée est un détecteur pour mesurer la conductibilité thermique d'un gaz, la cavité (20) dans le corps étant adaptée pour laisser passer un gaz à travers elle avec une membrane en nitrure de bore (40) formant un pont s'étendant latéralement à travers la cavité (20), et la structure comprenant en outre une résistance à film fin (38) supportée par le pont et recevant un courant de chauffe et une mesure de sa tension pour fournir une mesure de la conductibilité thermique du gaz.

3. Utilisation de la structure selon la revendication 1 dans laquelle la structure stratifiée est une soupape à fluide, dans laquelle la cavité dans le corps est adaptée pour laisser passer un fluide à travers elle, la membrane de nitrure de bore s'étendant à travers la cavité et le dispositif comprenant en outre des moyens d'étirement pour étirer la membrane de nitrure de bore dans la cavité de façon à restreindre le passage du fluide à travers la cavité.

4. Utilisation de la structure selon la revendication 3 dans laquelle la cavité est divisée en une première cavité et une seconde cavité par la membrane de nitrure de bore, la seconde cavité étant adaptée pour laisser passer le fluide à travers elle, et les moyens d'étirement comprenant un milieux thermiquement expansible remplissant la première cavité et comprenant en outre des moyens de chauffe pour chauffer le milieu afin de réaliser l'expansion du milieu de sorte que la membrane soit étirée dans la seconde cavité de façon à restreindre le passage du fluide à travers la seconde cavité.

5. Structure stratifiée comprenant :
un membre de tranche supérieur (56);
un membre de tranche inférieur (54);
un membre de tranche intermédiaire (48) lesdits membres supérieur, intermédiaire et inférieur étant couplés ensemble de façon à définir une cavité (52,58);
une membrane (60) ladite membrane étant couplée audit membre de tranche intermédiaire (48), ladite membrane (60) étant formée de nitrure de bore substantiellement exempt d'hydrogène ayant la composition nominale B₃N, ladite membrane (60) s'étendant dans ladite cavité (52,58) de façon à définir une partie supérieure (58) et une partie inférieure (52) de ladite cavité, ladite partie supérieure (58) de ladite cavité étant située entre ledit membre de tranche supérieur (56) et ladite membrane (60) et adaptée pour laisser passer un fluide, ladite partie inférieure (52) de ladite cavité s'étendant dans ledit membre de tranche intermédiaire (48) et étant délimitée par ladite membrane (60) et ledit membre de tranche inférieur (54);
un milieu thermiquement expansible remplissant ladite cavité inférieure (52); et
des moyens (64) pour chauffer ledit milieu afin de réaliser l'expansion dudit milieu de façon à ce que ladite membrane (60) s'étire à l'intérieur de ladite cavité supérieure (58) et restreigne le passage dudit fluide.

6. Structure selon la revendication 1 dans laquelle le membre de tranche inférieur est formé d'un seul cristal de silicium.

7. Structure selon la revendication 6, comprenant en outre un film de dioxyde de silicium disposé comme couche de liaison entre la membrane de nitrure de bore et le membre de tranche inférieur.

8. Structure selon la revendication 6 comprenant en outre une couche intermédiaire disposée entre la membrane de nitrure de bore et le membre de tranche inférieur, la couche intermédiaire étant formée de silicium dopé au bore.

9. Structure selon la revendication 1 dans laquelle la membrane en nitrure de bore est formée selon un procédé comprenant le dépôt par déposition en phase gazeuse à basse pression par procédé chimique d'un film de nitrure de bore hydrogéné sur le membre de tranche inférieur, et le chauffage du film de nitrure de bore dans un environnement exempt d'hydrogène et d'oxygène à une température suffisamment élevée et pendant une durée suffisante pour transformer le film de nitrure de bore en nitrure de bore substantiellement exempt d'hydrogène.

10. Structure selon la revendication 9 dans laquelle la température est comprise entre 1050°C et 1150°C et la durée dépasse environ une heure.

11. Procédé pour former une marche avec une paroi lisse dans un membre de tranche, comprenant la diffusion du bore dans une partie d'une aire sélectionnée d'une surface 〈100〉 d'un membre de tranche de silicium pour former une couche de diffusion du bore, et l'exposition de l'aire sélectionnée à un agent de gravure sélectif auquel la couche de diffusion du bore est résistante, de sorte que la couche de diffusion du bore forme une marche adjacente au silicium gravé dans le membre de tranche avec une paroi lisse substantiellement perpendiculaire à la surface 〈100〉.

12. Procédé selon la revendication 11 dans lequel la partie de l'aire sélectionnée présente des contours arrondis de façon à ce que la paroi lisse comprenne des arrondis lisses correspondant aux contours.

13. Procédé selon la revendication 11 dans lequel l'agent de gravure sélectif est l'éthylène diamine-pyrocatechol.

14. Procédé selon la revendication 11, dans lequel le bore est présent dans la couche de diffusion en une quantité comprise entre 10¹⁹ et 10²³ atomes/cm³.

15. Dispositif miniaturisé comprenant un membre de tranche de silicium présentant une marche avec une paroi lisse, formé par le procédé selon les revendications 11, 12 ou 13.

16. Dispositif selon la revendication 15 dans lequel la paroi lisse définit un côté d'un canal de circulation de fluide dans le membre de tranche.
